# EUROPEAN PATENT APPLICATION

(11) **EP 1 524 248 A1**
(43) Date of publication of application: **20.04.2005**
(21) Application number: 04024008.7
(22) Date of filing: 08.10.2004
(51) Int. Cl.: C03C 27/04, C03C 23/00, C03C 17/09, C03C 17/245, C30B 33/00

(54) **A method for bonding glass or metal fluoride optical materials to metal**

(30) Priority: 17.10.2003 US 511861 P; 09.08.2004 US 915026
(71) Applicant: CORNING INCORPORATED, Corning, NY 14831 (US)
(72) Inventor: Maier, Robert LeRoy, Ontario New York 14519 (US); McMaster, Brian Monroe, Pittsford New York 14534 (US)
(74) Representative: Sturm, Christoph, Dipl.-Ing.

(57) **Abstract**

The invention is directed to the use of energetic ion bombardment, in vacuum, to a surface of a metal fluoride crystal or optical element to remove contaminants on the surface and/or in micro-fractures. After cleaning, a suitable inert dielectric or metallic material is deposited onto the cleaned surface. A sealing agent is then applied to the inert material and a holder is placed about the entire assembly to hold and seal the metal fluoride element within the assembly. The method of the invention, and adhesion layer materials used in conjunction with the method, can be applied to glass elements as well as to metal fluoride single crystals and optical elements made from such crystals.

## Description

### Field of the Invention

The invention is directed to the sealing of glass or metal fluoride optical materials to metal surfaces and to a method of cleaning such surfaces prior to sealing.

### Background of the Invention

Making glass-to-metal seals is well known in the art and is ubiquitously exemplified by the ordinary incandescent light bulb. While many materials can be used as a sealing agent, one of the more preferred is the use of metallic indium as the sealing agent. Indium is well known to "wet" both glass and metal. Additionally, indium will "cold flow"; that is, will flow under pressure (compression) at ambient or near ambient temperatures due to its softness. A layer of indium is inserted between a glass surface and a metal surface, and pressure is applied causing the indium to flow and fill voids between the surfaces to form a seal. In addition, indium is a forgiving material due to its softness in that it maintains its seal over moderate temperatures as the mated parts (glass and metal) expand and contract. While patents have been obtained using indium as a sealing material, those skilled in the art still regard the use of this material and the overall sealing process as more "art" than "science". In particular, the techniques for obtaining clean, contamination free surfaces as well as maintaining the indium metal oxide-free (oxides reduce the malleability of the metal) are of the utmost importance. Various methods have been used for the cleaning process with success.

Metal fluoride single crystals such as those of the metals of Group IA (lithium and potassium) and IIA (magnesium, calcium, barium and strontium) have applications in many optical systems, and the Group IIA single crystals are the materials of choice for optical elements used in excimer laser assemblies operating at less than 300 nm; for example, at 248, 193 and 157 nm. In these applications it is desirable or necessary to seal an optical element made of a metal fluoride single crystal in a metallic holder. However, sealing metal fluoride crystals-to-metal is extremely challenging. For example, single crystals of calcium fluoride require purging by use of a pure, dry inert gas such as argon or nitrogen to prevent photodeposition of contaminants on the optical surfaces of the metal fluoride crystals. When existing methods of sealing are used for making such seals, low yields of sealed materials and assemblies result. This is economically unacceptable due to the expense of making metal fluoride single crystals, a process that can take several weeks to prepare an optically acceptable crystal.

As an example of the problems encountered, it is known that a few monolayers of water vapor and/or oxygen can adsorb onto optical surfaces. This adsorption can be shown by infrared spectroscopy in the 2800-3400 wavenumber region. For inert substances, for example, silica, these absorbed layers are easily removed prior to sealing. Removal techniques known in the art include chemical cleaning liquids, or oven baking in inert atmosphere such as dry nitrogen. For fluoride crystals the removal of such materials is more difficult. For example, fluoride crystals are chemically active. The presence of adsorbed water can give rise to chemical reactions resulting in the dissociation of water vapor as has been described by Wu et al., "X-Ray Photoelectron Spectroscopy Study of Water Adsorption on BaF₂ (111) and CaF₂ (111) surfaces", *Langmuir* Vol. 10 (1994), pages 1482-1487. The products of such dissociation are OH radicals and CaO which are strongly held to the metal fluoride substrates with energies in excess to ∼200 eV. Additional species such as CaF(OH) can also be formed. Standard cleaning techniques do not remove these bound species. The cleaning is further complicated by the fact that mechanical grinding of fluoride crystals results in numerous micro-fractures that extend below the surface to depth in the range of 300-1000 nm as has been reported by Jue Wang et al., "Surface characterization of polished CaF₂ crystal by quasi-Brewster angle technique", presentation at the August 2003 SPIE meeting held in San Diego, California. These micro-fractures collect and entrap contaminants from polishing slurries, grinding wheels, rinse solutions and other materials used in processing the crystals into optical elements. These materials may not only be difficult to detect, but they can also lead to poor fluoride-to-metal seals when indium is used as the sealing material.

As has already been stated, when existing methods of cleaning and of sealing are used for fluoride-to-metal seals, the results are low yields of sealed materials and assemblies. This is economically unacceptable due to the expense of making metal fluoride single crystals, a process that can take several weeks to prepare an optically acceptable crystal. Consequently, it is desirable to find an improved method for making metal fluoride single crystal-to-metal seals.

### Summary of the Invention

The invention is directed to a method of cleaning and preparing the surfaces of metal fluoride crystals such that the resulting surfaces are suitable for making metal fluoride single crystal-to-metal seals without resulting contamination of the optical surfaces of the single crystal. In particular, the method of the invention is directed to the use of energetic ion bombardment, in vacuum, of a metal fluoride crystal surface to remove contaminants, followed by vacuum deposition of a suitable dielectric or metallic material on the cleaned surface. The deposited materials serve as a non-oxidizing, non-contaminating adhesion layer for the indium metal used as a sealing agent. Suitable dielectric or metallic materials for deposition include silica (SiO2), or a metal (for example, nickel and chrome) and metal alloys (for example, NiCr). The method of the invention, and adhesion layer materials used in conjunction with the method, can be applied to glass as well as to metal fluoride single crystals.

The method of the invention is further directed to sealing a fluoride crystal within a holder, said method having the steps of:
removing contaminants from a metal fluoride element surface and micro-fractures in the surface by ion bombardment with ions of an inert gas;
forming a thin film of an inert material on the cleaned surface;
applying a sealant to said inert material;
placing a holder about the sealant; and
sealing the metal fluoride element within the holder and closing said holder about said sealant, inert material and metal fluoride element.

The invention is also directed to an optical element for use in an optical lithographic system, said element being held in a holder and having between the holder and the element a layer of inert material deposited on the surface of the optical element and a sealing agent between the inert material and the holder.

### Brief Description of the Drawings

Figure 1 illustrates ion cleaning of the surface and sub-surface fractures of a glass or a metal fluoride crystal substrate.
Figure 2 illustrates the deposition of a film of an adhesion material onto surfaces that have been cleaned as illustrated in Figure 1.
Figure 3 illustrates the application of a sealant and holder to the film of Figure 3.

### Detailed Description of the Invention

As used herein the terms "metal fluoride(s)", "fluoride crystal(s)", "metal fluoride single crystal(s)" and similar terms mean Group IA and IIA metal fluoride single crystals of general formulas M'F and MF₂, where M' is lithium and potassium and M is magnesium, calcium, barium and strontium. The terms further include mixed crystals of the foregoing; for example MM'F (e.g., a LiF/CaF₂ or MgF₂/CaF₂ mixed crystals) as well as crystals containing lanthanide series metal fluorides (e.g.., LaF₃/CaF₂). The terms further include other combination of the foregoing as can be set forth by one skilled in the art. In addition, the use of the term "sealing a metal fluoride crystal" includes sealing optical elements made from a metal fluoride crystal to metal. Examples, without limitation of such elements, are lenses and laser chamber windows.

Existing technologies for sealing glass-to-metal involve heat and/or pressure to facilitate the "cold flow" process for the bonding of glass-to-metal using, for example, metallic indium. However, while such methods are suitable for glass-to-metal, the use of heat and/or pressure is generally not suitable for use with metal fluoride crystals. As has already been mentioned above, the typical methods of grinding, cleaning and polishing metal fluoride surfaces can result in strongly adsorbed species on the surface and in micro-fractures that can form during such steps. Since the contamination cannot be easily removed by conventional cleaning methods, and since such methods may themselves contribute to the contamination, a different method of cleaning is clearly needed.

This invention is directed to a method of cleaning fluoride crystal surfaces in vacuum using energetic ion bombardment with ion energies typically greater than 600eV. Examples of such ions are those arising from noble gases such as argon, krypton, neon, xenon and helium as well as those arising from the use of nitrogen. Contaminants are removed from the surface and micro-fractures of the metal fluoride by momentum transfer. The contaminants are then pumped away by the vacuum system. However, once the fluoride surface has been cleaned it can be re-contaminated by exposure to the ambient atmosphere which contains water vapor, hydrocarbons and other contaminants. For example, chemical reaction between water vapor and a metal fluoride, for example, CaF₂ can recur with the formation of OH radicals, CaO, CaF(OH), etc. The invention presents this by depositing an inert film on the cleaned surface after ion cleaning. Suitable film materials include silica, nickel, chrome, alloys such as NiCr, and other materials that will not oxidize or otherwise react with adsorbed contaminants. Such contaminants can be easily removed from the surface of the film using conventional cleaning techniques prior to sealing.

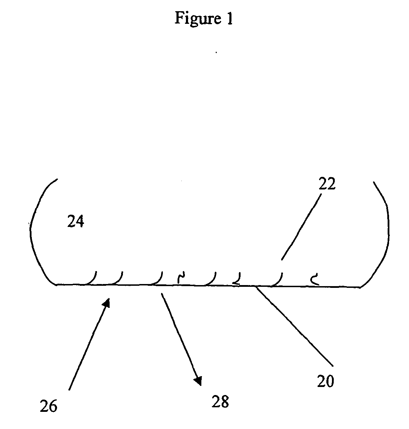

Figure 1 illustrates ion cleaning of a metal fluoride element or substrate 24, for example, an excimer laser optical window, having a polished surface 20 and micro-fractures 22 in the surface into which contaminants can lodge. The element is contained in a vacuum vessel (not illustrated) which also contains an ion beam source, and a gas source for the admittance of a dry gas after cleaning and a vacuum source attached to the vessel (all also not illustrated). An ion beam 26 from the ion source is directed to the surface and micro-fractures of the element 24. Contaminants 28 are removed from the surface 20 and/or the micro-fractures 22 by momentum transfer from the bombarding ions to the contaminants. Vacuum is applied during the process to remove contaminants removed from the surface of element 22 and from the vacuum vessel.

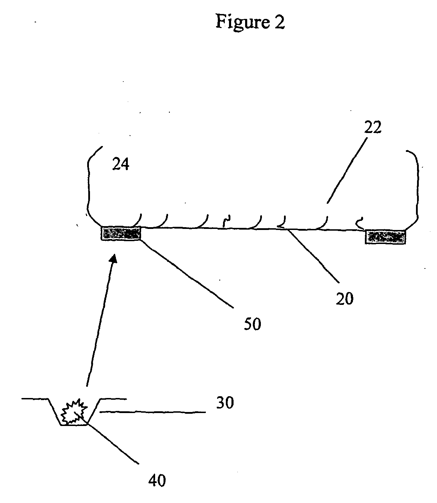

Figure 2 illustrates the deposition of a film of inert material on a surface cleaned as illustrated in Figure 1. A crucible 30 containing a material 40 is heated until material 40 vaporizes and deposits as inert film 50 on cleaned surface 20 of the substrate metal fluoride material 24. In an alternative method, sputtering techniques known in the art can be used to deposit inert film 50 on the substrate. The inert material will prevent re-contamination of the fluoride material surface 20 or the lodging of contaminants in the micro-fractures 22.

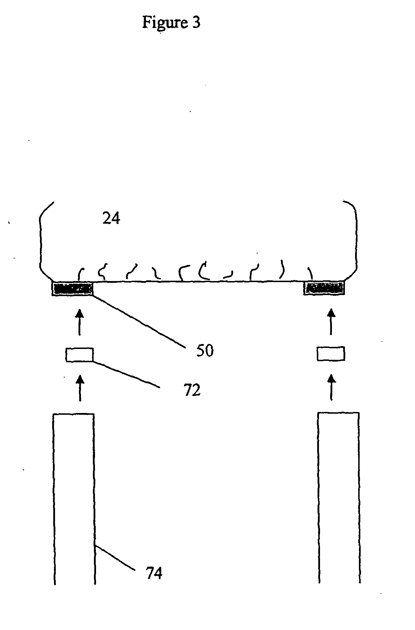

Figure 3 is a side view in cross section and illustrates sealing between a metal fluoride element or substrate 24 having an inert film 50 (illustrated as light grey) on an ion cleaned surface, layer of indium metal 72 and a holding/sealing element 74, preferably a metallic holding/sealing element.

The cleaning method described above can be used to make an optical element in a holder that can be used in optical lithographic systems, Such element can be a laser chamber window, a lens or other optical elements, The optical element in the holder is a glass or metal fluoride optical element having a thin layer of a dielectric material or a metal deposited on a cleaned surface of the element, a holder for holding the element, and a metallic indium sealant between said holder and said optical element. The optical element can be made from high purity fused silica; a metal fluoride of general formula M'F or MF₂ where M' is lithium or potassium and M is magnesium, calcium, barium or strontium; a mixed metal fluoride consisting of two or more of the foregoing metal fluorides; and a mixed metal fluoride containing one or more of the foregoing metal fluorides and a fluoride of one or more lanthanum series metals. The dielectric material used for the thin film can be any dielectric material suitable for the purpose, preferably silica. The metal used for the thin film can be nickel, chrome, an alloy of nickel and chrome, and other metals or alloys known to those skilled in the art that are suitable and can be deposited on the glass or metal fluoride surface by vapor deposition or sputtering. The holder can be metal or other material, for example, a polymeric material that is capable of withstanding the operational conditions to which the optical element in the holder will be subjected.

The foregoing examples of specific compositions, processes, articles and/or apparatus employed in the practice of the present invention are, of course, intended to be illustrative rather than limiting, and it will be apparent that numerous variations and modifications of these specific embodiments may be practiced within the scope of the appended claims.

## Claims

1. A method of sealing glass or a fluoride crystal or element within or to a holder, said method comprising the steps of:
removing contaminants from a glass or metal fluoride element surface and micro-fractures in the surface by ion bombardment with ions of an inert gas;
forming a thin film of an inert material on the cleaned surface;
applying a sealant to said inert material;
placing a holding/sealing element about the sealant; and
sealing the glass or metal fluoride element to or within the holding/sealing element and closing said holding/sealing element about said sealant, inert material and said glass or metal fluoride element.

2. The method according to claim 1 wherein the inert gas is selected from the group consisting of helium, argon, krypton, neon, xenon, and nitrogen.

3. The method according to claim 1 wherein the inert material is selected from the group consisting dielectric oxides and metal selected from the group consisting of nickel, chromium and alloys thereof.

4. The method according to claim 3, wherein the dielectric oxide is silica.

5. The method according to claim 1, wherein the sealing agent is metallic indium.

6. The method according to claim 1, wherein the holding/sealing element is a metallic element.

7. A optical element comprising:
a glass or metal fluoride optical element having a thin layer of a dielectric material or a metal deposited on a cleaned surface of the element,
a holder for holding the element, and
a metallic indium sealant between said holder and said optical element.

8. The optical element according to claim 7, wherein said cleaned surface is a surface clean by energetic ion bombardment prior to the deposition of said dielectric material or metal.

9. The optical element according to claim 9, wherein said optical element is made from a material selected from the group consisting of high purity fused silica; a metal fluoride of general formula M'F or MF₂ where M' is lithium or potassium and M is magnesium, calcium, barium or strontium; a mixed metal fluoride consisting of two or more of the foregoing metal fluorides; and a mixed metal fluoride containing one or more of the foregoing metal fluorides and a fluoride of one or more lanthanum series metals.

10. The optical element according to claim 7, wherein the dielectric material is silica.

11. The optical element according to claim 7, wherein the metal is selected from the group consisting of nickel, chrome and an alloy of nickel and chrome.
